# EUROPEAN PATENT APPLICATION

(11) **EP 1 641 055 A1**
(43) Date of publication of application: **29.03.2006**
(21) Application number: 05108609.8
(22) Date of filing: 19.09.2005
(51) Int. Cl.: H01L 51/40

(54) **Method for fabricating organic electroluminescence device**

(30) Priority: 23.09.2004 KR 2004076674
(71) Applicant: Samsung SDI Co., Ltd., Suwon-si Gyeonggi-do (KR)
(72) Inventor: Lee, Jae-Ho, Gyeonggi-do (KR); Kang, Tae-Min, Gyeonggi-do (KR); Kim, Jin-Soo, Gyeonggi-do (KR); Lee, Seong-Taek, Gyeonggi-do (KR)
(74) Representative: Hengelhaupt, Jürgen

(57) **Abstract**

The present invention provides a method for fabricating an organic electroluminescence device comprising forming an organic layer on the substrate by irradiating a laser beam onto a predetermined region of a donor substrate by a laser irradiation apparatus equipped with a diffractive optical element. A method for fabricating an organic electroluminescence device according to the present invention has merits that energy efficiency of a laser beam is improved by using a diffractive optical element when forming an organic film layer pattern by LITI, and fabrication process of the organic electroluminescence device is simplified and fabrication cost of the organic electroluminescence device is reduced by replacing a mask only when forming a laser beam having various shapes to fabricate the organic electroluminescence device.

## Description

### CROSS REFERENCE

This application claims the benefit of Korean Patent Application No. 2004-76674, filed on September 23, 2004, the disclosure of which is hereby incorporated herein by reference in its entirety.

### BACKGROUND OF THE INVENTION

### Field of the invention

The present invention relates to a method for fabricating an organic electroluminescence device, more particularly, to a method for forming the organic film layer pattern using a laser irradiation apparatus equipped with a diffractive optical element when forming an organic layer pattern by laser induced thermal imaging (LITI).

### Description of Related Art

Generally, an organic electroluminescence device that is a flat panel display comprises an anode electrode and a cathode electrode, and organic layers disposed between the anode electrode and the cathode electrode.

The organic layers comprise at least an emitting layer and further comprise a hole injection layer, a hole transport layer, an electron transport layer and an electron injection layer in addition to the emitting layer. The organic electroluminescence device is classified into a high molecular organic electroluminescence device and a small molecular organic electroluminescence device according to materials composing the organic layers, particularly the emitting layer.

The emitting layer should be patterned to realize full coloration of the organic electroluminescence device, wherein a method for patterning the emitting layer includes a photolithography process using a shadow mask in case of the small molecular organic electroluminescence device, and an ink-jet printing method or a laser induced thermal imaging (hereinafter referred to as "LITI") method using laser in case of the high molecular organic electroluminescence device. The LITI method has merits that it is capable of patterning the organic layers finely, is applied to a large area and is favorable to high resolution, and the LITI method is a dry process while the ink-jet printing method is a wet process.

A method for forming patterns of the organic layers by the LITI method requires at least a laser generator, an organic electroluminescence device substrate and a donor substrate. A method of patterning organic layers on the substrate comprises a step of absorbing a laser beam coming out of the laser generator into a light-to-heat conversion layer of the donor substrate such that the laser beam is converted into thermal energy, and a step of transferring a material composing a transfer layer onto the substrate by the thermal energy. The method of patterning organic layers on the substrate is disclosed in Korean Patent Application No. 1998-51844 and United States Patent Nos. 5,998,085, 6,214,520 and 6,114,088.

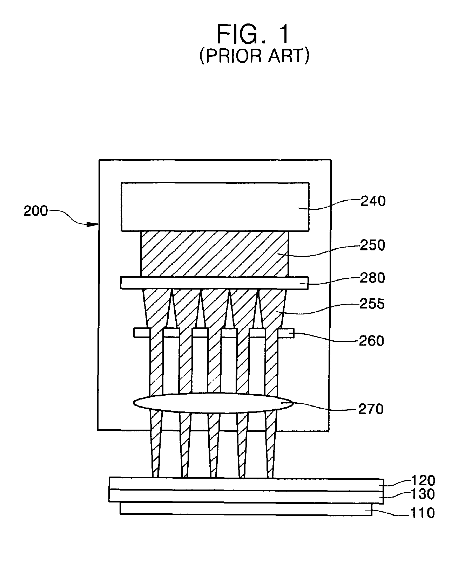

FIG. 1 is a schematic drawing for explaining a method for fabricating an organic electroluminescence device according to the prior art.

Referring to FIG. 1, a substrate 110 on which a pixel electrode is formed is provided. Subsequently, a donor substrate 120 on which an organic layer 130 is formed is laminated on the pixel electrode formed substrate 110.

An organic layer pattern is formed on the pixel electrode formed substrate 110 by irradiating a laser beam 150 onto the donor substrate 120 using a laser irradiation apparatus 100.

The laser irradiation apparatus 100 comprises a laser generator 140, a patterned mask 160 and a projection lens 170. An organic layer pattern is formed on the substrate 110 by forming a laser beam 150 generated by the laser generator 140 as a pattern having a desired shape through the patterned mask 160 formed on a lower part of the laser generator 140 such that the laser beam 150 is irradiated onto the donor substrate 110.

All laser beams 150 generated from the laser generator 140 do not pass through the patterned mask 160. That is, although a laser beam irradiated on a patterned part of the mask 160 is irradiated onto the projection lens 170 through the mask 160, a laser beam irradiated on a non-patterned part of the mask 160 is cut off by the mask 160. Therefore, a large amount of laser beam including the laser beam cut off by the mask 160 is required to form the organic layer pattern. After all, there is a problem that efficiency of laser beam is deteriorated.

### SUMMARY OF THE INVENTION

Therefore, in order to solve the foregoing problem of the prior art, it is an object of the present invention to provide a method for fabricating an organic electroluminescence device, that is capable of improving energy efficiency of laser beam by using a diffractive optical element when forming an organic layer pattern by LITI and that is capable of reducing cost by forming an organic layer pattern having various shapes in the state that only a mask is replaced.

In order to achieve the foregoing object, the present invention provides a method for fabricating an organic electroluminescence device comprising a step of providing a substrate on which a pixel electrode is formed, a step of laminating a donor substrate on the front of the substrate, and a step of forming an organic layer pattern on the substrate by irradiating a laser beam onto a predetermined region of the donor substrate using a laser irradiation apparatus equipped with a diffractive optical element.

The laser irradiation apparatus comprises a laser generator, a diffractive optical element formed under the laser generator to diffract a laser beam generated from the laser generator, a patterned mask formed under the diffractive optical element, and a projection lens formed under the patterned mask.

The step of forming the organic layer pattern on the pixel electrode is performed at an atmoshphere of nitrogen gas (N₂) or in a vacuum environment.

The organic layer pattern is a single layer or multilayer selected from the group consisting of an emitting layer, a hole injection layer, a hole transport layer, an electron transport layer and an electron injection layer.

### BRIEF DESCRIPTION OF THE DRAWINGS

The above and other features and advantages of the present invention will become more apparent to those of ordinary skill in the art by describing in detail preferred embodiments thereof with reference to the attached drawings in which:
FIG. 1 is a schematic drawing for explaining a method for fabricating an organic electroluminescence device according to the prior art; and
FIG. 2 is a schematic drawing for explaining a method for fabricating an organic electroluminescence device according to the present invention.

### DETAILED DESCRIPTION OF THE INVENTION

The present invention will now be described in detail in connection with preferred embodiments with reference to the accompanying drawings. For reference, like reference characters designate corresponding parts throughout several views.

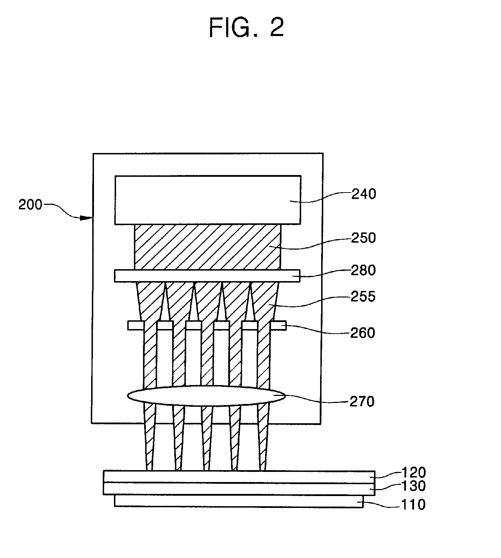

FIG. 2 is a schematic drawing for explaining a method for fabricating an organic electroluminescence device according to the present invention.

Referring to FIG. 2, a substrate 110 on which a pixel electrode is formed is provided. Subsequently, a donor substrate 120 on which an organic layer 130 is formed is laminated on the pixel electrode formed substrate 110. The organic layer 130 formed donor substrate 120 is laminated on the substrate 110 by vacuum adsorption or pressurization roller.

Continuously, an organic layer pattern is formed on the pixel electrode formed substrate 110 by irradiating a laser beam 250 onto the donor substrate 120 using a laser irradiation apparatus 200 equipped with a diffractive optical element.

The laser irradiation apparatus 200 comprises a laser generator 240, a diffractive optical element 280, a patterned mask 260 and a projection lens 270.

The diffractive optical element 280 is formed under the laser generator 240 and designed in advance to form an organic layer pattern of a desired shape. The diffractive optical element 280 as an optical element using diffraction phenomenon of light adjusts the focus of the lens by a method for corresponding phases, wherein the diffractive optical element 280 as an element having thin thickness has the same effect that the laser beam passes through the same optical path in a refraction lens since the laser beam reaches the image point as the same phase although laser beams passing through respective courses do not have the same optical path while a laser beam generated from the laser generator reaches an image point. In aspects except optical characteristics, the diffractive optical element 280 has reduced volume and weight due to thin thickness compared with a refraction element, is easily fabricated by a simple fabrication method compared with the refraction element, and reduces fabrication cost by enabling the diffractive optical element 280 to be produced in a mass quantity by a method such as extrusion molding.

The diffractive optical element 280 diffracts an incidence laser beam 250 generated from the laser generator 240 to a pattern part of the mask 260. Therefore, a laser beam is diffracted by the diffractive optical element 280 such that the diffracted laser beam is irradiated onto the projection lens 270 by passing through the mask in the state that the laser beam is not cut off by the mask differently from that the laser beam is conventionally cut off by the mask. That is, energy efficiency of the laser beam is improved by forming the organic layer pattern without loss of the laser beam 250 generated from the laser generator 240.

Furthermore, fabrication process of the diffractive optical element 280 becomes complicated, and fabrication cost of the diffractive optical element 280 is increased since the diffractive optical element 280 should be fabricated again correspondingly to the pattern to form an organic layer pattern of various shapes. However, a method for fabricating an organic electroluminescence device 280 according to the present invention simplifies the fabrication process and reduces fabrication cost by fabricating only the mask 260 correspondingly to a desired pattern in the state that the diffractive optical element 280 is remained as it is.

An organic layer pattern is formed on the substrate 110 by irradiating the laser beam onto the donor substrate 110 after a laser beam 255 diffracted by the diffractive optical element 280 is refracted through the projection lens 270 formed under the diffractive optical element 280.

A process of forming the organic film layer can be performed at an atmosphere of nitrogen gas (N₂). The transfer process can be performed at a nitrogen atmosphere from which oxygen is removed since there is the possibility of oxidation of the organic layer pattern to be transferred due to existence of oxygen in an ordinary atmosphere. Furthermore, the transfer process can be performed in a vacuum environment to obtain an effect of suppressing generation of air bubbles between the donor substrate and the substrate during the foregoing laminating process.

The organic layer pattern formed in the transfer process can be a single layer or multilayer selected from the group consisting of an emitting layer, a hole injection layer, a hole transport layer, an electron transport layer and an electron injection layer.

An organic electroluminescence device is completed by forming a cathode electrode on the organic layer pattern after performing a transfer process of forming the organic layer pattern.

As described in the above, a method for fabricating an organic electroluminescence device according to the present invention has merits that energy efficiency of a laser beam is improved by using a diffractive optical element when forming an organic layer pattern by LITI, and fabrication process of the organic electroluminescence device is simplified and fabrication cost of the organic electroluminescence device is reduced by replacing a mask only when forming a laser beam having various shapes to fabricate the organic electroluminescence device.

While the invention has been particularly shown and described with reference to preferred embodiments thereof, it will be understood by those skilled in the art that the foregoing and other changes in form and details may be made therein without departing from the spirit and scope of the invention.

## Claims

1. A method for fabricating an organic electroluminescence device comprising:
providing a substrate on which a pixel electrode is formed;
laminating a donor substrate on the front of the substrate;
and
forming an organic layer pattern on the substrate by irradiating a laser beam onto a predetermined region of the donor substrate using a laser irradiation apparatus.

2. The method according to claim 1, wherein the laser irradiation apparatus comprises a laser generator; a diffractive optical element formed under the laser generator to diffract a laser beam generated from the laser generator; a patterned mask formed under the diffractive optical element; and a projection lens formed under the patterned mask.

3. The method according to claim 1, wherein forming the organic layer pattern on the pixel electrode is performed at an atmoshphere of nitrogen gas (N₂).

4. The method according to claim 1, wherein forming the organic layer pattern on the pixel electrode is performed in a vacuum environment.

5. The method according to claim 1, wherein the organic layer pattern is a single layer or multilayer selected from the group consisting of an emitting layer, a hole injection layer, a hole transport layer, an electron transport layer and an electron injection layer.
